(19) **Europäisches Patentamt / European Patent Office / Office européen des brevets**

(11) **EP 4 585 953 A1**

(12) # EUROPEAN PATENT APPLICATION

(43) Date of publication:
16.07.2025   Bulletin 2025/29

(51) International Patent Classification (IPC):
**G01R 33/56** (2006.01)        **G01R 33/561** (2006.01)

(21) Application number: 24151851.3

(22) Date of filing: 15.01.2024

(52) Cooperative Patent Classification (CPC):
**G01R 33/5608;** G01R 33/5611

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Healthineers AG
91301 Forchheim (DE)**

(72) Inventor: **Nickel, Marcel Dominik
91074 Herzogenaurach (DE)**

(74) Representative: **Siemens Healthineers
Patent Attorneys
Postfach 22 16 34
80506 München (DE)**

(54)     **MAGNETIC RESONANCE IMAGE RECONSTRUCTION**

(57)     For MR image reconstruction, MR measurement data representing an imaged object (6) is obtained and, for each iteration of at least two iterations, a prior MR image for the respective iteration is received, an optimized MR image (21) is generated by optimizing a predefined first loss function, which depends on the MR measurement data and on the prior MR image, and an enhanced MR image (22) is generated by applying a trained machine learning model, MLM, for image enhancement to the optimized MR image (21). The prior MR image of the respective iteration corresponds to the enhanced MR image (22) of a preceding iteration, unless the respective iteration corresponds to an initial iteration of the at least two iterations, and the prior MR image of the initial iteration corresponds to a predefined initial image (20).

FIG 2

EP 4 585 953 A1

**Description**

The present invention is directed to a computer implemented method for magnetic resonance, MR, image reconstruction and to a computer implemented training method for training a machine learning model, MLM, for image enhancement for use in such a computer implemented method for MR image reconstruction. The invention is further directed to a data processing apparatus for carrying out said computer implemented method for MR image reconstruction and/or said a computer implemented training method and to a corresponding computer program product.

Here and in the following, the term image denotes an image in position space, also denoted as image space or image domain, unless stated otherwise. In MR imaging, image reconstruction denotes the process to generate a two-dimensional image or a three-dimensional image, typically in form of multiple two-dimensional images for multiple positions along the so-called slice direction, in position space from the MR data acquired in k-space depending on MR signals being emitted by an object to be imaged.

In general, the k-space and the position space are related to each other via Fourier transformation. When parallel MR imaging is pursued, MR data are received from multiple receiver coils, which receive the emitted MR signals. Furthermore, k-space subsampling techniques may be employed, where the k-space is sampled with a sampling rate that is too low to fulfil the Nyquist criterion. The latter is also denoted as undersampling or incomplete sampling. The multiple coils or the data provided by them, respectively, are denoted as coil channels. The reconstructed MR image can therefore not be obtained solely by Fourier transforming the acquired k-space data. Rather, more sophisticated reconstruction techniques need to be used. Various methods for MR image reconstruction are known, which may for example involve iterative processes and/or optimizations based on physical relations.

In the reconstruction process, application specific parameters may be taken into account. These parameters may origin from different physical contexts depending on the specific application. The parameters may for example be related to the motion of an object to be imaged during data acquisition, the specific underlying k-space sampling pattern, and so forth.

Furthermore, trained machine learning models, MLMs, for example artificial neural networks, ANNs, in particular deep convolutional neural networks, CNNs, may be used for the MR image reconstruction, for example in combination with conventional reconstruction approaches. Therein, "conventional" refers to the fact that no MLM is involved. Such methods are sometimes called deep learning, DL, reconstructions. A review of the topic is presented in the publication G. Zeng et al.: "A review on deep learning MRI reconstruction without fully sampled k-space." BMC Med Imaging 21, 195 (2021).

U-Net, introduced in the publication of O. Ronneberger et al.: "U-Net: Convolutional Networks for Biomedical Image Segmentation" (arXiv:1505.04597v1), is a well-known CNN usable for example for image segmentation or image enhancement.

One approach to train MLMs, in particular ANNs, is supervised training. Therein, training data, for example training MR images in the present context, and corresponding ground truth data, for example a reconstructed MR image in the present context, are provided. The training data is fed to the MLM, which outputs a prediction, which is then compared to the ground truth data by evaluating a loss function. The loss function may be minimized to train the MLM.

In view of the application specific parameters mentioned above, one can for example train a dedicated MLM for each application. This, however, increases the overall training effort, in particular in terms of the total computational time required for the training of all MLMs, the required amount of training data, and so forth.

CAIPIRINHA is a parallel imaging technique using group unique k-space sampling patterns. In this way, pixel aliasing and overlap may be avoided. The points measured in k-space are shifted by applying offsets to the phase-encoding gradients. Wave-CAIPI is a variant of CAIPIRINHA operating with a 3D pattern that uses coil sensitivities along the readout direction and is described, for example, in the publication D. Polak et al.: "Wave-CAIPI for highly accelerated MP-RAGE imaging.", Magnetic resonance in medicine, 79.1 (2018): 401-406.

SENSE based models are described in the publications K.P. Pruessmann et al.: "SENSE: sensitivity encoding for fast MRI.", Magn Reson Med. 1999 Nov, 42(5):952-62, K.P. Pruessmann et al.: " Advances in Sensitivity Encoding With Arbitrary k-Space Trajectories", Magn Reson Med. 2001, 46:638-651, and M. Uecker et al.: " ESPIRiT - an eigenvalue approach to autocalibrating parallel MRI: where SENSE meets GRAPPA.", Magn Reson Med. 2014 Mar, 71(3):990-1001.

The publication M. W. Haskell et al.: "TArgeted Motion Estimation and Reduction (TAMER): data consistency based motion mitigation for MRI using a reduced model joint optimization." IEEE transactions on medical imaging 37.5 (2018): 1253-1265, describes how parameters describing a rigid object motion during MR data acquisition may be used for motion compensation by minimizing a data consistency error of a SENSE forward model.

The publication D. Polak et al. "Scout accelerated motion estimation and reduction (SAMER)." Magnetic Resonance in Medicine 87.1 (2022): 163-178 describes motion estimation and reduction using a low-resolution scout scan and sequence reordering to independently determine motion states by minimizing the data-consistency error in a SENSE plus motion forward model.

The publication M. W. Haskell et al.: "Network accelerated motion estimation and reduction (NAMER): convolutional neural network guided retrospective motion correction using a separable motion model.", Magnetic resonance in medicine 82.4 (2019): 1452-1461 describes how a convolutional neural network can be trained to remove motion artifacts from 2D T2-weighted rapid acquisition with refocused echoes images and how it can be introduced into a model-based data-consistency optimization to determine motion parameters.

It is an objective of the present invention to overcome this problem at least in part.

This objective is achieved by the subject matter of the independent claims. Further implementations and preferred embodiments are subject matter of the dependent claims.

The invention is based on the idea to formulate the reconstruction problem such that the MLM is formally separated from terms, which are affected by said application specific parameters. The same trained MLM can then be used for various applications.

According to an aspect of the invention, a computer implemented method for MR image reconstruction, is provided. Therein, MR measurement data representing an imaged object is obtained and at least two iterations including an initial iteration and a final iteration are carried out in the following manner. For each iteration of the at least two iterations,

a) a prior MR image for the respective iteration is received, and

b) an optimized MR image is generated by optimizing, in particular minimizing, a predefined first loss function, which depends on the MR measurement data and on the prior MR image. Furthermore,

c) an enhanced MR image is generated by applying a trained machine learning model, MLM, for image enhancement to the optimized MR image. Therein,

d) unless the respective iteration corresponds to the initial iteration of the at least two iterations, the prior MR image of the respective iteration corresponds to the enhanced MR image of a preceding iteration, in particular an iteration directly preceding the current iteration. The prior MR image of the initial iteration corresponds to a predefined initial image.

Unless stated otherwise, all steps of the computer implemented method may be performed by a data processing apparatus, which comprises at least one computing unit. In particular, the at least one computing unit is configured or adapted to perform the steps of the computer implemented method. For this purpose, the at least one computing unit may for example store a computer program comprising instructions which, when executed by the at least one computing unit, cause the at least one computing unit to execute the computer implemented method.

In particular, the enhanced MR of a final iteration of the at least two iterations corresponds to a reconstructed MR image of the object.

The MLM is an MLM for image enhancement. In other words, an input to the MLM is an image, in the present case the optimized MR image, and an output of the MLM is an image as well, in the present case the enhanced MR image. Therein, the output image is enhanced with respect to the input image. What exactly is the effect of the enhancement depends on the training data and the corresponding ground truth data used for training the MLM. For example, the at training data may be intentionally corrupted or deteriorated using for example blurring filters, adding noise, and so forth. By means of the training, the MLM learns to enhance an input image accordingly.

For example, in case the MLM is an ANN, it may be a U-Net, as described in the publication of O. Ronneberger et al mentioned in the introductory part of the present disclosure, or an ANN based on the U-Net architecture.

The optimization of the first loss function may be carried out by using known optimization techniques, for example optimizations according to gradient-based techniques or the like. The optimization may, in particular be carried out iteratively itself. In this case, the at least two iterations may be considered as outer iterations, while the optimization may comprise inner iterations.

The initial image may for example be a guess for the reconstructed MR image or it may also be an image with constant pixel values everywhere, for example zero. Each iteration provides the enhanced MR image as another preliminary candidate for the reconstructed MR image, thus iteratively achieving an increased quality of the eventual reconstructed MR image as the enhanced MR image of the final iteration.

Evaluating a loss function can be understood as computing a corresponding value of loss function.

The total number of the at least two iterations is not necessarily very large, it can for example lie in the range of 2 to 20 iterations or 2 to 10 iterations or 3 to 7 iterations. Thus, the computational effort is limited.

The MR measurement data may for example be given in k-space. The data acquisition may be carried out with full sampling of the k-space or with incomplete sampling, also denoted as undersampling.

An undersampled MR data acquisition is an acquisition, whose k-space sampling scheme does not fulfil the Nyquist criterion. The k-space sampling scheme may for example be defined by a discrete function $p(k)$, wherein k denotes coordinates, for example three-dimensional or two-dimensional coordinates, in k-space and $p(k)$ is non-zero, for example equal to one, only at coordinates in k-space, which shall be sampled or, in other words, measured, and equal to zero otherwise.

The data acquisition may also be carried out as parallel or multi-coil acquisition, wherein the MR data are received from multiple receiver coils, which receive the MR signals emitted from the object to be imaged. In parallel imaging, the acquired multi-coil data are related to the reconstructed images through a signal model, which depends on respective coil sensitivity maps of the multiple coil channels. The MR measurement data may then comprise respective data for all coil channels and may be denoted as parallel imaging MR measurement data.

In general terms, a trained MLM may mimic cognitive functions that humans associate with other human minds. In particular, by training based on training data the MLM may be able to adapt to new circumstances and to detect and extrapolate patterns. Another term for a trained MLM is "trained function".

In general, parameters of an MLM can be adapted by means of training. In particular, supervised training, semi-supervised training, unsupervised training, reinforcement learning and/or active learning can be used. Furthermore, representation learning, also denoted as feature learning, can be used. In particular, the parameters of the MLMs can be adapted iteratively by several steps of training. In particular, within the training a certain loss function, also denoted as cost function, can be minimized. In particular, within the training of an NN, the backpropagation algorithm can be used.

In particular, an MLM can comprise an ANN, a support vector machine, a decision tree and/or a Bayesian network, and/or the machine learning model can be based on k-means clustering, Q-learning, genetic algorithms and/or association rules. In particular, an ANN can be or comprise a deep neural network, a convolutional neural network or a convolutional deep neural network. Furthermore, an ANN can be an adversarial network, a deep adversarial network and/or a generative adversarial network.

By means of the invention, the trained MLM is formally separated from the first loss function. The first loss function may be adapted to various use cases or applications by including application specific parameters as if the reconstruction would be a conventional reconstruction, that is a reconstruction without using an MLM. The trained MLM itself is not affected by such modifications of the first loss function. Consequently, the same trained MLM may be used for various applications without having to be re-trained.

According to several implementations, the MLM is an ANN, for example a CNN.

According to several implementations, the MR measurement data corresponds to data measured according to at least two coil channels. In other words, the MR measurement data corresponds parallel imaging MR measurement data.

According to several implementations, the optimization of the first loss function is carried out under variation of a variable MR image, while the prior MR image is kept constant during the optimization, in particular of a given iteration.

The variable MR image can be understood as the respective optimization variables of the optimization. As a result of the optimization, the optimal variable MR image corresponds to the optimized MR image.

For example, the first loss function comprises a data term, which depends on the MR measurement data and on encoded data, which is given by a predefined MR signal model matrix applied to the variable MR image.

In particular, the measurement data is parallel imaging MR measurement data in this case. The signal model matrix may also be denoted as encoding matrix. The measurement data and the variable MR image may also be given in matrix form, such that the application of the signal model matrix applied to the variable MR image corresponds to a matrix multiplication.

For example, the data term quantifies a deviation between the MR measurement data and the encoded MR data. In some implementations or use cases, respectively, the MR measurement data may be modified and the data term quantifies a deviation between the modified MR measurement data and the encoded MR data. The data term ensures data consistency and is therefore also denoted as data consistency term.

The data term may for example be given by

$$\|E\, x - y\|^2$$

wherein E denotes the signal model matrix, x denotes the variable MR image and y denotes the MR measurement data. The double vertical lines may denote the L1-norm.

For example, the signal model matrix may depends on respective predefined coil sensitivity maps for each of the at least two coil channels. The coil sensitivity maps may in general be determined by methods known in the art.

The signal model matrix may for example contain a Fourier transform and a coil sensitivity map matrix, which contains the predefined coil sensitivity maps for all coil channels. In case undersampling is used, the signal model matrix may also comprise the sampling scheme p(k). The signal model matrix may for example comprise a product of the coil sensitivity map matrix and the Fourier transform and, in case of undersampling, the sampling scheme p(k).

For example, the first loss function may comprise a regularization term, which depends on the prior MR image and the variable MR image. In particular, the regularization term quantifies a deviation between the prior MR image and variable MR image of the respective iteration.

The regularization term may for example be given by a Tikhonov regularization term. The first loss function, in particular, comprises or consists of a sum of the data term and the regularization term.

The regularization term may for example depend on the L1-norm of the difference between the prior MR image of the respective iteration and the variable MR image. For example, the regularization term may be given by

$$\frac{1}{\lambda_n}\, \|x - x_n\|^2\,,$$

wherein n denotes the respective iteration, $x_n$ denotes the prior MR image of the respective iteration, and $\lambda_n$ denotes a regularization weight. The regularization weight may be the same for all of the at least two iterations or it may be different for different iterations.

According to several implementations, a point spread function for a data acquisition process used for generating the MR measurement data is received and the signal model matrix depends on the point spread function.

The point spread function describes, how a hypothetical point-like object would be imaged after reconstruction. In general, such a point-like object does not appear as an exact point in the reconstructed MR image but appears blurred. Considering a real object to be composed of multiple point-like objects, the point spread function may predict how the object appears in the reconstructed MR image.

The point spread function generally depends fundamentally on the used acquisition process. In respective implementations of the invention, this dependency is treated separately from the MLM part of the reconstruction allowing for various different applications using the same trained MLM.

The point spread function depends, in particular, on coefficients defining the data acquisition process. For example, the data acquisition process is a CAIPIRINHA acquisition, in particular a Wave-CAIPI acquisition. It is referred to the publication of D. Polak et al. "Wave-CAIPI [...]" mentioned above for further details.

According to several implementations, the signal model matrix depends on translation offsets describing a rigid motion of the imaged object and/or the signal model matrix depends on rotation angles describing the rigid motion of the imaged object. In particular, the signal model matrix depends on the respective translation offsets and/or rotation angles for each sampled k-space position.

Compensation of rigid motion of the imaged object is a well-known problem in MR imaging and various approaches are known to solve it.

In particular, for rigid motion, for which the current motion position may be characterized by six parameters, namely three translation offsets and three rotation angles. The may be integrated into the signal model matrix to consider the motion effects in the reconstruction.

The parameters, namely translation offsets and/or rotation angles, may be determined through joint iteration of image and parameters as described in the publication of M. W. Haskell et al. "TArgeted Motion [...]" mentioned above. The parameters may also be precalculated by correlation with a scout acquisition, as described in the publication of D. Polak et al. "Scout accelerated [...]" mentioned above. The parameters may also be estimated with the help of an ANN, which is independent of the MLM, as described in the publication of M. W. Haskell et al. "Network accelerated [...]" mentioned above.

In such implementations, the invention allows to use the same trained MLM for reconstructions with and without considering rigid motion compensation and also for different methods to take into account the rigid motion.

According to several implementations, the signal model matrix depends on a deformation vector field describing a non-rigid deformation of the imaged object.

Compensation of non-rigid motion of the imaged object is a well-known problem in MR imaging and various approaches are known to solve it. The non-rigid motion corresponds, for example, to a deformation of patient tissues due to respiratory and/or cardiac motion.

In this case, the acquired data may be assigned to motion states or motion phases. The corresponding images are related by an elastic warping, which can be included in the signal model matrix by introducing the respective parameters parameterizing the deformation vector fields.

In such implementations, the invention allows to use the same trained MLM for reconstructions with and without considering non-rigid motion compensation and also for different methods to take into account the non-rigid motion.

According to a further aspect of the invention, a method for MR image reconstruction is provided. Therein, the MR measurement data representing an imaged object is generated by an MRI scanner and a computer implemented method for MR image reconstruction according to the invention is carried out.

According to a further aspect of the invention, Computer implemented training method for training an MLM for image enhancement for use in a computer implemented method for MR image reconstruction according to the invention is provided. Therein, training MR data is received, and a ground truth reconstructed MR image corresponding to the training MR data is received. At least two training iterations including an initial training iteration and a final training iteration are carried out as follows. For each training iteration of the at least two training iterations,

a') a training prior MR image for the respective training iteration is received, and
b') an optimized training MR image is generated by optimizing a predefined second loss function, which depends on the training MR data and on the training prior MR image.

c') An enhanced training MR image is generated by applying the MLM to the optimized training MR image. Therein, d') unless the respective training iteration corresponds to the initial training iteration, the training prior MR image of the respective training iteration corresponds to the enhanced training MR image of a preceding training iteration. The training prior MR image of the initial training iteration corresponds to a predefined initial training image.

A predefined third loss function is evaluated depending on the enhanced training MR image of the final training iteration and the ground truth reconstructed MR image. The MLM is updated depending on a result of the evaluation of the third loss function.

As mentioned above, the output image of MLM is enhanced with respect to its input image. What exactly is the effect of the enhancement depends on the training MR measurement data and the ground truth reconstructed MR image. For example, the training MR data may be intentionally corrupted or deteriorated using for example blurring filters, adding noise, and so forth. By means of the training, the MLM learns to enhance an input image accordingly.

The input to the MLM, for example the ANN, is the optimized MR image of the respective training iteration and its output is the enhanced MR image. However, the evaluation of the third loss function is not carried out for each iteration but only after all of the two or more iterations have been carried out. Thus, also the optimization of the step b') is included in the training process, which leads to an increased training efficiency.

The MLM may for example be an ANN, in particular a CNN, for example a U-Net or an architecture based on the U-Net. In this case, updating the MLM can be understood as updating network parameters, in particular network weights and/or bias factors, of the ANN. The updating may be done by using known algorithms, such as backpropagation.

The third loss function may also be a known loss function used for training image enhancement ANNs, such as for example a pixel-wise loss function, for example an L1-loss function or an L2-loss function.

The described steps including the at least two iterations, the evaluation of the third loss function, and the update of the MLM are, in particular, understood as a single training run. A plurality of such runs may be carried out consecutively, until a predetermined termination or convergence criterion regarding the second loss function is reached. Each set of at least one training image may be denoted as a training sample. The number of training samples may lie in the order of 10000 or several times 10000. The number of training epochs may for example lie in the order 100-1000. The total number of training runs is for example given by the product of the number of training samples and the number of training epochs.

It is noted that said application specific parameters, for example parameters of the point spread function of the acquisition process for generating the MR measurement data, parameters specifying said rigid or non-rigid motion, and so forth, are not necessarily considered for training the MLM, in particular are not necessarily contained in the second loss function.

According to several implementations, the ground truth reconstructed MR image is generated assuming full k-space sampling.

According to several implementations, the optimization of the second loss function is carried out under variation of a variable MR image, while the training prior MR image is kept constant during the optimization. The second loss function comprises a data term, which depends on the training MR data and on further encoded data, which is given by a predefined further MR signal model matrix applied to the variable MR image.

According to several implementations, the second loss function comprises a regularization term, which depends on the prior MR image and the variable MR image.

In particular, the second loss function may be identical to the first loss function without considering said application specific parameters.

According to several implementations of the computer implemented method for MR image reconstruction, the MLM is trained or has been trained by using a computer implemented training method according to the invention.

The computer implemented method for MR image reconstruction may, in some implementations, comprise training the MLM by using a computer implemented training method according to the invention. In other implementations, the computer implemented method for MR image reconstruction does not include the steps of the computer implemented training method.

According to several implementations of the computer implemented method for MR image reconstruction, the MLM is trained by using a computer implemented training according to the invention. The computer implemented method for MR image reconstruction is carried out such that the point spread function for the data acquisition process used for generating the MR measurement data is received and the signal model matrix used for the MR image reconstruction depends on the point spread function. The further MR signal model matrix used for the training is independent of the point spread function.

According to several implementations of the computer implemented method for MR image reconstruction, the MLM is trained by using a computer implemented training according to the invention. The computer implemented method for MR image reconstruction is carried out such that the signal model matrix depends on the translation offsets and/or the signal model matrix depends on the rotation angles describing the rigid motion of the imaged object. The further MR signal model matrix is independent of the translation offsets and independent of the rotation angles.

According to several implementations of the computer implemented method for MR image reconstruction, the MLM is trained by using a computer implemented training according to the invention. The computer implemented method for MR image reconstruction is carried out such that the signal model matrix depends on the deformation vector field describing the non-rigid deformation of the imaged object. The further MR signal model matrix is independent of the deformation vector field.

According to a further aspect of the invention, a data processing apparatus comprising at least one computing unit is provided. The at least one computing unit is adapted to carry out a computer implemented training method according to the invention and/or a computer implemented method for MR image reconstruction according to the invention.

A computing unit may in particular be understood as a data processing device, which comprises processing circuitry. The computing unit can therefore in particular process data to perform computing operations. This may also include operations to perform indexed accesses to a data structure, for example a look-up table, LUT.

In particular, the computing unit may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing unit may also include one or more processors, for example one or more microprocessors, one or more central processing units, CPU, one or more graphics processing units, GPU, and/or one or more signal processors, in particular one or more digital signal processors, DSP. The computing unit may also include a physical or a virtual cluster of computers or other of said units.

In various embodiments, the computing unit includes one or more hardware and/or software interfaces and/or one or more memory units.

A memory unit may be implemented as a volatile data memory, for example a dynamic random access memory, DRAM, or a static random access memory, SRAM, or as a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a further aspect of the invention, a system for MR imaging is provided. The system comprises a data processing apparatus according to the invention, wherein the at least one computing unit is adapted carry out a computer implemented method for MR image reconstruction according to the invention. The system comprises an MRI scanner. The at least one computing unit is adapted to control the MRI scanner to generate the at least two measured MR images.

According to a further aspect of the invention, a first computer program comprising first instructions is provided. When the first instructions are executed by a data processing apparatus, the first instructions cause the data processing apparatus to carry out a computer implemented training method according to the invention.

The first instructions may be provided as program code, for example. The program code can for example be provided as binary code or assembler and/or as source code of a programming language, for example C, and/or as program script, for example Python.

According to a further aspect of the invention, a second computer program comprising second instructions is provided. When the second instructions are executed by a data processing apparatus, the second instructions cause the data processing apparatus to carry out a computer implemented method for MR image reconstruction according to the invention.

The second instructions may be provided as program code, for example. The program code can for example be provided as binary code or assembler and/or as source code of a programming language, for example C, and/or as program script, for example Python.

According to a further aspect of the invention, a computer-readable storage medium, in particular a tangible and non-transient computer-readable storage medium, storing a first computer program and/or a second computer program according to the invention is provided.

The first computer program, the second computer program and the computer-readable storage medium are respective computer program products comprising the first instructions and/or the second instructions.

Further features and feature combinations of the invention are obtained from the figures and their description as well as the claims. In particular, further implementations of the invention may not necessarily contain all features of one of the claims. Further implementations of the invention may comprise features or combinations of features, which are not recited in the claims.

Above and in the following, the solution according to the invention is described with respect to the claimed systems as well as with respect to the claimed methods. Features, advantages or alternative embodiments herein can be assigned to the other claimed objects and vice versa. In other words, claims and embodiments for the systems can be improved with features described or claimed in the context of the respective methods. In this case, the functional features of the method are implemented by physical units of the system.

Furthermore, above and in the following, the solution according to the invention is described with respect to methods and systems for MR image reconstruction as well as with respect to methods and systems for providing a trained MLM. Features, advantages or alternative embodiments herein can be assigned to the other claimed objects and vice versa. In other words, claims and embodiments for providing a trained MLM can be improved with features described or claimed in the context of MR image reconstruction. In particular, datasets used in the methods and systems can have the same properties and features as the corresponding datasets used in the methods and systems for providing a trained MLM, and the trained MLMs provided by the respective methods and systems can be used in the methods and systems for MR image reconstruction.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,

FIG 1    shows a schematic block diagram of an exemplary implementation of a system for MR imaging according to the invention;

FIG 2    shows a schematic flow diagram of an exemplary implementation of a computer implemented method for MR image reconstruction according to the invention;

FIG 3    shows a schematic flow diagram of an exemplary implementation of a computer implemented training according to the invention;

FIG 4    shows a schematic representation of a convolutional neural network; and

FIG 5    shows a schematic representation of a further convolutional neural network.

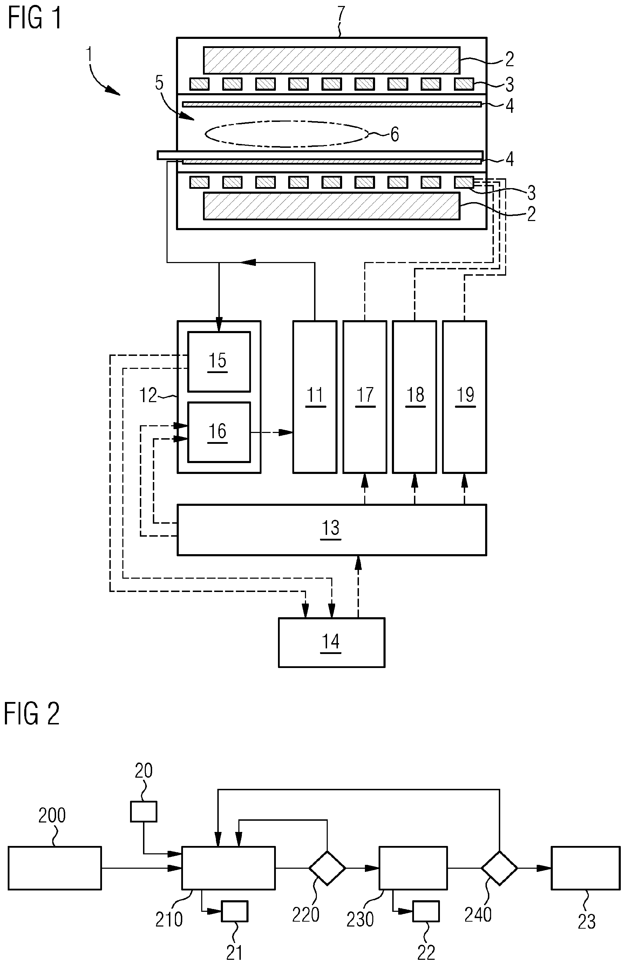

FIG 1 shows schematically an exemplary implementation of a system for MR imaging, also denoted as MRI system 1, according to the invention. The MRI system 1 comprises a housing 7 defining a bore 5 and a main magnet arrangement 2, which is configured to generate a main magnetic field, also denoted as polarizing magnetic field, within the bore 5. The MRI system 1 comprises an RF system 55, 11, 12, which is configured to apply an asymmetric RF pulse to a target material, in particular a body part of a patient 6, disposed within the bore 5 and to receive MR signals from the target material. For example, the main magnet arrangement 2 may generate a uniform main magnetic field B0 as the main magnetic field and at least one RF coil 4 of the RF system 4, 11, 12 may emit an excitation field B1. The MRI system 1 comprises a data processing apparatus with at least one computing unit 13, 14, which is configured to construct the asymmetric RF pulse by using a computer implemented method for constructing an asymmetric RF pulse according to the present disclosure.

To this end, the at least one computing unit 13, 14 determines a first RF amplitude for a predefined first part of a predefined time interval, and receives an RF amplitude curve, which depends on at least one RF curve parameter. The at least one computing unit 13, 14 determines a combined RF amplitude curve for the time interval by combining, in particular concatenating, the first RF amplitude for the first part of the time interval and the RF amplitude curve for a predefined second part of the time interval, which succeeds the first part of the time interval. The at least one computing unit 13, 14 carries out an optimization to optimize the combined RF amplitude curve using a loss function, which comprises an energy loss term, which depends on a pulse energy of the combined RF amplitude curve, and using the at least one RF curve parameter as at least one optimization variable. The at least one computing unit 13, 14 determines the asymmetric RF pulse, wherein a combined amplitude of the asymmetric RF pulse for the time interval is given by the optimized combined RF amplitude curve.

According to MR techniques, the target material is subjected to the main magnetic field, causing the nuclear spins in the target material to precess about the main magnetic field at their characteristic Larmor frequency. A net magnetic moment Mz is produced in the direction z of the main magnetic field, and the randomly oriented magnetic moments of the nuclear spins cancel out one another in the x-y-plane.

When the target material is then subjected to the transmit RF magnetic field, which is for example in the x-y plane and near the Larmor frequency, the net magnetic moment rotates out of the z-direction generating a net in-plane magnetic moment, which rotates in the x-y plane with the Larmor frequency. In response, MR signals are emitted by the excited spins when they return to their state before the excitation. The emitted MR signals are detected, for example by the at least one RF coil 4 and/or one or more dedicated detection coils, digitized in a receiver channel 15 of an RF controller 12 of the RF system 4, 11, 12, and processed by at least one processor 14 of the at least one computing unit 13, 14 to reconstruct an MR image using for example a computer implemented method for MR image reconstruction according to the invention.

In particular, gradient coils 3 of the MRI system 1 may produce magnetic field gradients Gx, Gy, and Gz for position-encoding of the MR signals. Accordingly, MR signals are emitted only by such nuclei of the target material, which correspond to the particular Larmor frequency. For example, Gz is used together with a bandwidth-limited RF pulse to select a slice perpendicular to the z-direction and consequently may also be denoted as slice selection gradient. In alternative example, Gx, Gy, and Gz may be used in any predefined combination with a bandwidth-limited RF pulse to select a slice perpendicular to the vector sum of said gradient combination. The gradient coils 3 may be supplied with current by respective amplifiers 17, 18, 19 for generating the respective gradient fields in x-direction, y-direction, and z-direction, respectively. Each amplifier 17, 18, 19 may include a respective digital-to-analog converter, which is controlled by the sequence controller 13 to generate respective gradient pulses at predefined time instances.

It is noted that the components of the MRI system 1 can also be arranged differently from the arrangement shown in FIG 1. For example, the gradient coils 3 may be arranged inside the bore 5, similar as shown for the at least one RF coil 4.

A sequence controller 13 of the at least one computing unit 13, 14 may control the generation of RF pulses by an emitter channel 16 of the RF controller 12 and an RF power amplifier 11 of the RF system 4, 11, 12.

The least one processor 14 may receive the real and imaginary parts from analog-digital converters of the receiver channel 15 and reconstruct the MR image based on them.

It is noted that each component of the MRI system 1 may include other elements which are required for the operation thereof, and/or additional elements for providing functions other than those described in the present disclosure.

FIG 2 shows a schematic flow diagram of an exemplary implementation of a computer implemented method for MR image reconstruction according to the invention.

In step 200 MR measurement data representing an imaged object 6 is obtained, in particular from the MRI system 1. For each iteration of at least two iterations, a prior MR image for the respective iteration is received. The prior MR image of an initial iteration of the at least two iterations is given by a predefined initial image 20. In steps 210 and 220, an optimized MR image 21 is generated by optimizing a predefined first loss function, which depends on the MR measurement data and on the prior MR image. The optimization may be carried out iteratively as well. Step 210 then corresponds to an optimization step, while in step 220, it is determined whether a termination or convergence criterion for the optimization is reached. If this is not the case, another optimization step 210 is carried out, otherwise the optimized MR image 21 is further processed in step 230.

In step 230, an enhanced MR image 22 is generated by applying the trained MLM to the optimized MR image 21. The prior MR image of the respective iteration is given by the enhanced MR image 22 of the corresponding preceding iteration, unless the respective iteration corresponds to the initial iteration. In step 240, it is determined whether a predefined total number of the at least two iterations has been carried out. If this is not the case, the next iteration is carried out.

Otherwise, the reconstructed MR image 23 is determined as the enhanced MR image 22 of a final iteration of the at least two iterations.

MR image reconstruction can be based on a signal model matrix or encoding matrix E that connects the reconstructed image x to the acquired MR measurement data y. It may involve modeling of the coil sensitivity maps, a Fourier transformation and the k-space trajectory of the acquisition.

The data consistency can then be measured through the cost function

[1]

$$L = \|Ex - y\|^2.$$

Since the signal model matrix may be imperfect and not perfectly conditioned, one may use additional prior information or regularization. Particularly deep learning has provided big improvements in image quality and significant acceleration of scans.

According to several implementations of the invention, a deep learning based reconstruction is employed, which iteratively calculates images $x_n$ by alternating between data consistency updates, for example in the negative direction of the loss function's gradient, and image regularization by the MLM, which is for example a CNN, in particular a U-Net based CNN, for image enhancement. Several implementations of the invention make use of a formulation, wherein these two types of steps are split according to

[2.1]

$$x_{n+1/2} = \operatorname*{argmin}_{x}(\|Ex - y\|^2 - \frac{1}{\lambda_n}\|x - x_n\|^2)$$

$$[2.2]$$
$$x_{n+1} = R_n(x_{n+1/2}).$$

Therein, n 6 [0, N) iterations are sequentially performed to provide the final reconstructed MR image $x_N$. The initial prior image $x_0$ may be a guess or identical to zero, for example. $\lambda_n$ are Lagrange multipliers that may be determined within the training and $R_n$ is the trained MLM for image enhancement. The coefficients $\lambda_n$ provide an interpolation between the current prior image $x_n$ at $\lambda_n = 0$ and the parallel imaging solution at $\lambda_n = \infty$. In conventional reconstructions they correspond to a Tikhonov regularization.

In particular for rigid motion, for which the current motion position is characterized by six parameters, namely three translation offsets and three rotation angles, the motion can be considered in the reconstruction. In this case the signal model matrix includes the motion correction for each k-space sample. The additional parameters may be labeled as $\theta$ and the cost function is generalized to

$$[3]$$
$$L = \|E_\theta x - y\|^2.$$

The parameters $\theta$ may for example be determined through joint iteration of image and parameters, pre-calculated by correlation with a scout acquisition or determined with help of a neural network, which is not related to the MLM, however, but only used for determining the parameters $\theta$.

In the variable splitting approach, the optimization is extended to to

$$[4.1]$$
$$x_{n+1/2} = \underset{x}{\operatorname{argmin}}(\|E_\theta x - y\|^2 - \frac{1}{\lambda_n}\|x - x_n\|^2)$$

$$[4.2]$$
$$x_{n+1} = R_n(x_{n+1/2}).$$

Similarly, there are other acquisition types such as Wave-CAIPI, where the conventional reconstruction is of the form of equation [3], namely

$$[5]$$
$$L = \|E_\gamma x - y\|^2,$$

where $\gamma$ denotes the coefficients of the point-spread function. Similarly, the reconstruction can be combined with a deep learning-based reconstruction to

$$[6.1]$$
$$x_{n+1/2} = \underset{x}{\operatorname{argmin}}(\|E_\gamma x - y\|^2 - \frac{1}{\lambda_n}\|x - x_n\|^2)$$

$$[6.2]$$
$$x_{n+1} = R_n(x_{n+1/2}).$$

The reconstruction may for example be trained based on a conventional CAIPIRINHA sampling pattern.

For cardiac imaging and abdominal images, for example, the MR measurement data may be assigned to motion states or phases. The corresponding images are related by an elastic warping which can be included in the encoding matrix. In this case the parameters included into E parameterize the motion vector fields.

According to several implementations, a DL reconstruction that involves the optimization of a data consistency term which amounts to a conventional, regularized parallel imaging reconstruction is provided and during inference, this component is replaced by a reconstruction term with additional parameters.

According to several implementations, the architecture of the DL reconstruction involves variable splitting and alternates between a conventional parallel imaging reconstruction and a network regularization using the MLM.

According to several implementations, a conventional parallel imaging reconstruction is performed iteratively and for a single outer iteration, few inner iterations are performed. In total, the iterations are sufficient for the convergence of the conventional reconstruction. In this way, the network regularizations are weaved into the conventional reconstruction.

According to several implementations, additional application specific parameters, which are associated with motion correction, are considered in the signal model matrix.

According to several implementations, additional application specific parameters, which are associated with assignment to motion states or phases, are considered in the signal model matrix.

According to several implementations, additional application specific parameters, which are associated with corrupted data, such as spikes, are considered in the signal model matrix.

According to several implementations, additional application specific parameters, which are associated with weighting parameters of the sampling in the loss function, are considered in the signal model matrix.

According to several implementations, the additional application specific parameters are only determined at the beginning of the reconstruction or at few points in the reconstruction process.

According to several implementations, the additional application specific parameters are determined by an ANN, which is trained for example in a supervised manner using augmented training data.

According to several implementations, the DL reconstruction that is trained on non-corrupted data including a step with a conventional, regularized parallel imaging reconstruction and the conventional, regularized parallel imaging reconstruction is replaced by a more involved reconstruction to correct additional effects during inference.

According to several implementations, the DL reconstruction is trained with augmented data and includes adverse effects during training.

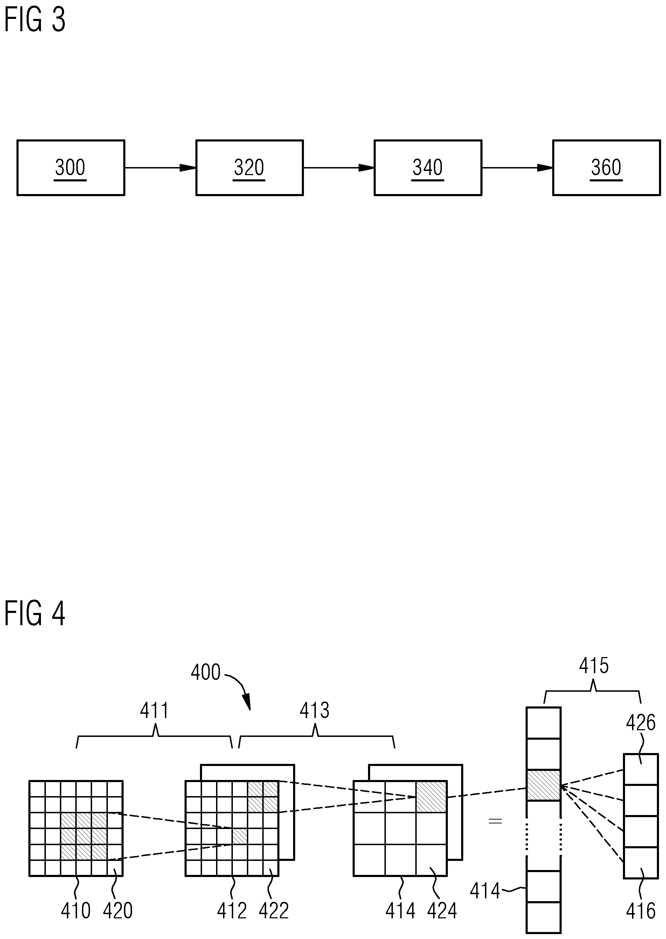

FIG 3 shows a schematic flow diagram of an exemplary implementation of a computer implemented training according to the invention.

In step 300, training MR data is received, and a ground truth reconstructed MR image corresponding to the training MR data is received. In step 320, at least two training iterations are carried out, similar as described with respect to FIG 2. For each training iteration of the at least two training iterations, a training prior MR image for the respective training iteration is received, an optimized training MR image is generated by optimizing a predefined second loss function, which depends on the training MR data and on the training prior MR image, and an enhanced training MR image is generated by applying the MLM to the optimized training MR image. The training prior MR image of the respective training iteration corresponds to the enhanced training MR image of a preceding training iteration, unless the respective training iteration corresponds to an initial training iteration of the at least two training iterations, and the training prior MR image of the initial training iteration corresponds to a predefined initial training image.

In step 340, a predefined third loss function is evaluated depending on the enhanced training MR image of a final training iteration of the at least two training iterations and the ground truth reconstructed MR image. In step 360, the MLM is updated depending on a result of the evaluation of the third loss function.

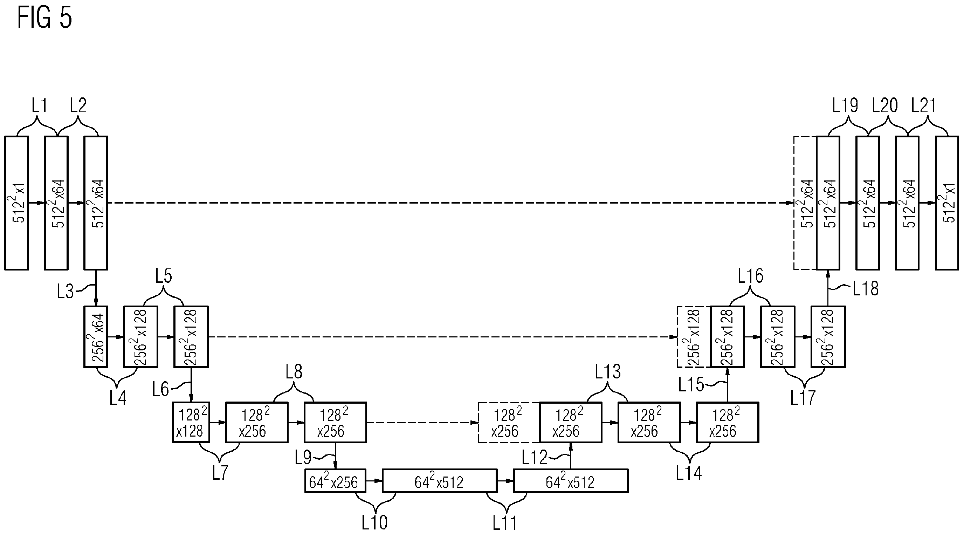

The MLM may for example be an ANN, in particular a CNN, as schematically depicted in FIG 4, FIG 5.

A CNN is an ANN that uses a convolution operation instead general matrix multiplication in at least one of its layers. These layers are denoted as convolutional layers. In particular, a convolutional layer performs a dot product of one or more convolution kernels with the convolutional layer's input data, wherein the entries of the one or more convolution kernel are parameters or weights that may be adapted by training. In particular, one can use the Frobenius inner product and the ReLU activation function. A convolutional neural network can comprise additional layers, for example pooling layers, fully connected layers, and/or normalization layers.

By using convolutional neural networks, the input can be processed in a very efficient way, because a convolution operation based on different kernels can extract various image features, so that by adapting the weights of the convolution kernel the relevant image features can be found during training. Furthermore, based on the weight-sharing in the convolutional kernels less parameters need to be trained, which prevents overfitting in the training phase and allows to have faster training or more layers in the network, improving the performance of the network.

FIG 4 displays an exemplary embodiment of a convolutional neural network 400. In the displayed embodiment, the convolutional neural network 400 comprises an input node layer 410, a convolutional layer 411, a pooling layer 413, a fully connected layer 414 and an output node layer 416, as well as hidden node layers 412, 414. Alternatively, the convolutional neural network 400 can comprise several convolutional layers 411, several pooling layers 413 and/or several fully connected layers 415, as well as other types of layers. The order of the layers can be chosen arbitrarily, usually fully connected layers 415 are used as the last layers before the output layer 416.

In particular, within a convolutional neural network 400 nodes 420, 422, 424 of a node layer 410, 412, 414 can be considered to be arranged as a d-dimensional matrix or as a d-dimensional image. In particular, in the two-dimensional case the value of the node 420, 422, 424 indexed with i and j in the n-th node layer 410, 412, 414 can be denoted as x(n)[i, j]. However, the arrangement of the nodes 420, 422, 424 of one node layer 410, 412, 414 does not have an effect on the calculations executed within the convolutional neural network 400 as such, since these are given solely by the structure and the weights of the edges.

A convolutional layer 411 is a connection layer between an anterior node layer 410 with node values x(n-1) and a posterior node layer 412 with node values x(n). In particular, a convolutional layer 411 is characterized by the structure and the weights of the incoming edges forming a convolution operation based on a certain number of kernels. In particular, the structure and the weights of the edges of the convolutional layer 411 are chosen such that the values x(n) of the nodes 422 of the posterior node layer 412 are calculated as a convolution x(n) = K * x(n-1) based on the values x(n-1) of the nodes 420 anterior node layer 410, where the convolution * is defined in the two-dimensional case as

$$x^{(n)}[i,j] = \left(K * x^{(n-1)}\right)[i,j] = \sum_{i'}\sum_{j'} K[i',j'] \cdot x^{(n-1)}[i-i', j-j'].$$

Herein, the kernel K is a d-dimensional matrix, in the present example a two-dimensional matrix, which is usually small compared to the number of nodes 420, 422, for example a 3x3 matrix, or a 5x5 matrix. In particular, this implies that the weights of the edges in the convolution layer 411 are not independent, but chosen such that they produce said convolution equation. In particular, for a kernel being a 3x3 matrix, there are only 9 independent weights, each entry of the kernel matrix corresponding to one independent weight, irrespectively of the number of nodes 420, 422 in the anterior node layer 410 and the posterior node layer 412.

In general, convolutional neural networks 400 use node layers 410, 412, 414 with a plurality of channels, in particular, due to the use of a plurality of kernels in convolutional layers 411. In those cases, the node layers can be considered as (d+1)-dimensional matrices, the first dimension indexing the channels. The action of a convolutional layer 411 is then in a two-dimensional example defined as

$$x_b^{(n)}[i,j] = \sum_{a}\left(K_{a,b} * x_a^{(n-1)}[i,j]\right) = \sum_{a}\sum_{i'}\sum_{j'} K_{a,b}[i',j'] \cdot x_a^{(n-1)}[i-i', j-j'],$$

wherein $x_a^{(n)}$ corresponds to the a-th channel of the anterior node layer 410, $x_b^{(n)}$ corresponds to the b-th channel of the posterior node layer 412 and $K_{a,b}$ corresponds to one of the kernels. If a convolutional layer 411 acts on an anterior node layer 410 with A channels and outputs a posterior node layer 412 with B channels, there are A·B independent d-dimensional kernels $K_{a,b}$.

In general, in convolutional neural networks 400 activation functions may be used. In this embodiment, ReLU (rectified linear unit) is used, with R(z) = max(0, z), so that the action of the convolutional layer 411 in the two-dimensional example is

$$x_b^{(n)}[i,j] = R\left(\sum_{a}\left(K_{a,b} * x_a^{(n-1)}[i,j]\right)\right)$$
$$= R\left(\sum_{a}\sum_{i'}\sum_{j'} K_{a,b}[i',j'] \cdot x_a^{(n-1)}[i-i', j-j']\right).$$

It is also possible to use other activation functions, for example ELU (exponential linear unit), LeakyReLU, Sigmoid, Tanh or Softmax.

In the displayed embodiment, the input layer 410 comprises 36 nodes 420, arranged as a two-dimensional 6x6 matrix. The first hidden node layer 412 comprises 72 nodes 422, arranged as two two-dimensional 6x6 matrices, each of the two matrices being the result of a convolution of the values of the input layer with a 3x3 kernel within the convolutional layer 411. Equivalently, the nodes 422 of the first hidden node layer 412 can be interpreted as arranged as a three-dimensional 2x6x6 matrix, wherein the first dimension correspond to the channel dimension.

An advantage of using convolutional layers 411 is that spatially local correlation of the input data can exploited by enforcing a local connectivity pattern between nodes of adjacent layers, in particular by each node being connected to only a small region of the nodes of the preceding layer.

A pooling layer 413 is a connection layer between an anterior node layer 412 with node values x(n-1) and a posterior node layer 414 with node values x(n). In particular, a pooling layer 413 can be characterized by the structure and the weights of the edges and the activation function forming a pooling operation based on a non-linear pooling function f. For example, in the two-dimensional case the values x(n) of the nodes 424 of the posterior node layer 414 can be calculated based on the values x(n-1) of the nodes 422 of the anterior node layer 412 as

$$x_b^{(n)}[i,j] = f\left(x_b^{(n-1)}[id_1, jd_2], \dots, \quad x_b^{(n-1)}[(i+1)d_1 - 1, (j+1)d_2 - 1]\right).$$

In other words, by using a pooling layer 413, the number of nodes 422, 424 can be reduced by re-placing a number d1.d2 of neighboring nodes 422 in the anterior node layer 412 with a single node 422 in the posterior node layer 414 being calculated as a function of the values of said number of neighboring nodes. In particular, the pooling function f can be the max-function, the average, or the L2-Norm. In particular, for a pooling layer 413 the weights of the incoming edges are fixed and are not modified by training. The advantage of using a pooling layer 413 is that the number of nodes 422, 424 and the number of parameters is reduced. This leads to the amount of computation in the network being reduced and to a control of overfitting.

In the displayed embodiment, the pooling layer 413 is a max-pooling layer, replacing four neighboring nodes with only one node, the value being the maximum of the values of the four neighboring nodes. The max-pooling is applied to each d-dimensional matrix of the previous layer. In this embodiment, the max-pooling is applied to each of the two two-dimensional matrices, reducing the number of nodes from 72 to 18.

In general, the last layers of a convolutional neural network 400 may be fully connected layers 415. A fully connected layer 415 is a connection layer between an anterior node layer 414 and a posterior node layer 416. A fully connected layer 413 can be characterized by the fact that a majority, in particular, all edges between nodes 414 of the anterior node layer 414 and the nodes 416 of the posterior node layer are present, and wherein the weight of each of these edges can be adjusted individually.

In this embodiment, the nodes 424 of the anterior node layer 414 of the fully connected layer 415 are displayed both as two-dimensional matrices, and additionally as non-related nodes, indicated as a line of nodes, wherein the number of nodes was reduced for a better presentability. This operation is also denoted as flattening. In this embodiment, the number of nodes 426 in the posterior node layer 416 of the fully connected layer 415 smaller than the number of nodes 424 in the anterior node layer 414. Alternatively, the number of nodes 426 can be equal or larger.

Furthermore, in this embodiment the Softmax activation function is used within the fully connected layer 415. By applying the Softmax function, the sum the values of all nodes 426 of the output layer 416 is 1, and all values of all nodes 426 of the output layer 416 are real numbers between 0 and 1. In particular, if using the convolutional neural network 400 for categorizing input data, the values of the output layer 416 can be interpreted as the probability of the input data falling into one of the different categories.

In particular, convolutional neural networks 400 can be trained based on the backpropagation algorithm. For preventing overfitting, methods of regularization can be used, for example dropout of nodes 420, ..., 424, stochastic pooling, use of artificial data, weight decay based on the L1 or the L2 norm, or max norm constraints.

In the example of FIG 5, the MLM is a CNN, in particular, a convolutional neural network having a U-net structure. In the displayed example, the input data to the CNN is a two-dimensional medical image comprising 512x512 pixels, every pixel comprising one intensity value. The CNN comprises convolutional layers indicated by solid, horizontal arrows, pooling layers indicating by solid arrows pointing down, and upsampling layers indicated by solid arrows pointing up. The number of the respective nodes is indicated within the boxes. Within the U-net structure first the input images are downsampled, in particular by decreasing the size of the images and increasing the number of channels. Afterwards they are upsampled, in particular by increasing the size of the images and decreasing the number of channels, to generate a transformed image.

All except the last convolutional layers L1, L2, L4, L5, L7, L8, L10, L11, L13, L14, L16, L17, L19, L20 use 3x3 kernels with a padding of 1, the ReLU activation function, and a number of filters or convolutional kernels that matches the number of channels of the respective node layers as indicated in FIG 5. The last convolutional layer uses a 1x1 kernel with no padding and the ReLU activation function.

The pooling layers L3, L6, L9 are max-pooling layers, replacing four neighboring nodes with only one node, the value being the maximum of the values of the four neighboring nodes. The upsampling layers L12, L15, L18 are transposed convolution layers with 3x3 kernels and stride 2, which effectively quadruple the number of nodes. The dashed horizontal errors correspond to concatenation operations, where the output of a convolutional layer L2, L5, L8 of the downsampling branch of the U-net structure is used as additional inputs for a convolutional layer L13, L16, L19 of the upsampling branch of the U-net structure. This additional input data is treated as additional channels in the input node layer for the convolutional layer L13, L16, L19 of the upsampling branch.

Independent of the grammatical term usage, individuals with male, female or other gender identities are included within the term.

## Claims

1. Computer implemented method for magnetic resonance, MR, image reconstruction, wherein MR measurement data representing an imaged object (6) is obtained and, for each iteration of at least two iterations,

   a) a prior MR image for the respective iteration is received;
   b) an optimized MR image (21) is generated by optimizing a predefined first loss function, which depends on the MR measurement data and on the prior MR image;
   c) an enhanced MR image (22) is generated by applying a trained machine learning model, MLM, for image enhancement to the optimized MR image (21); and
   d) the prior MR image of the respective iteration corresponds to the enhanced MR image (22) of a preceding iteration, unless the respective iteration corresponds to an initial iteration of the at least two iterations, and the prior MR image of the initial iteration corresponds to a predefined initial image (20).

2. Computer implemented method according to claim 1, wherein the optimization of the first loss function is carried out under variation of a variable MR image, while the prior MR image is kept constant during the optimization.

3. Computer implemented method according to claim 2, wherein the first loss function comprises a regularization term, which depends on the prior MR image and the variable MR image.

4. Computer implemented method according to one of claims 2 or 3, wherein the first loss function comprises a data term, which depends on the MR measurement data and on encoded data, which is given by a predefined MR signal model matrix applied to the variable MR image.

5. Computer implemented method according to claim 4, wherein the data term quantifies a deviation between the MR measurement data and the encoded MR data.

6. Computer implemented method according to one of claims 4 or 5, wherein

   - the MR measurement data corresponds to data measured according to at least two coil channels; and
   - the signal model matrix depends on respective predefined coil sensitivity maps for each of the at least two coil channels.

7. Computer implemented method according to one of claims 4 to 6, wherein

   - a point spread function for a data acquisition process used for generating the MR measurement data is received; and
   - the signal model matrix depends on the point spread function.

8. Computer implemented method according to one of claims 4 to 7, wherein the signal model matrix depends on translation offsets describing a rigid motion of the imaged object (6) and/or the signal model matrix depends on rotation angles describing the rigid motion of the imaged object (6).

9. Computer implemented method according to one of claims 4 to 8, wherein the signal model matrix depends on a deformation vector field describing a non-rigid deformation of the imaged object (6).

10. Computer implemented training method for training an MLM for image enhancement for use in a computer implemented method according to one of the preceding claims, wherein

    - training MR data is received and a ground truth reconstructed MR image corresponding to the training MR data is received;

- for each training iteration of at least two training iterations,

a') a training prior MR image for the respective training iteration is received;
b') an optimized training MR image is generated by optimizing a predefined second loss function, which depends on the training MR data and on the training prior MR image;
c') an enhanced training MR image is generated by applying the MLM to the optimized training MR image;
d') the training prior MR image of the respective training iteration corresponds to the enhanced training MR image of a preceding training iteration, unless the respective training iteration corresponds to an initial training iteration of the at least two training iterations, and the training prior MR image of the initial training iteration corresponds to a predefined initial training image;

- a predefined third loss function is evaluated depending on the enhanced training MR image of a final training iteration of the at least two training iterations and the ground truth reconstructed MR image; and
- the MLM is updated depending on a result of the evaluation of the third loss function.

11. Computer implemented training method according to claim 10, wherein

- the optimization of the second loss function is carried out under variation of a variable MR image, while the training prior MR image is kept constant during the optimization; and
- the second loss function comprises a data term, which depends on the training MR data and on further encoded data, which is given by a predefined further MR signal model matrix applied to the variable MR image.

12. Computer implemented method according to one of claims 1 to 9, wherein the MLM is trained by using a computer implemented training according to one of claims 10 or 11.

13. Computer implemented method for MR image reconstruction, wherein the MLM is trained by using a computer implemented training according to claim 11, and

- the computer implemented method for MR image reconstruction is carried out according to claim 7 and the further MR signal model matrix is independent of the point spread function; and/or
- the computer implemented method for MR image reconstruction is carried out according to claim 8 and the further MR signal model matrix is independent of the translation offsets and independent of the rotation angles; and/or
- the computer implemented method for MR image reconstruction is carried out according to claim 9 and the further MR signal model matrix is independent of the deformation vector field.

14. Data processing apparatus comprising at least one computing unit (13, 14), which is adapted to carry out a computer implemented method according to one of claims 1 to 9 or 12 to 13 or a computer implemented training method according to one of claims 10 or 11.

15. Computer program product comprising instructions, which, when executed by a data processing apparatus, cause the data processing apparatus to carry out a computer implemented method according to one of claims 1 to 9 or 12 to 13 or a computer implemented training method according to one of claims 10 or 11.

FIG 1

FIG 2

## FIG 3

| 300 | → | 320 | → | 340 | → | 360 |

## FIG 4

FIG 5

Europäisches
Patentamt

European
Patent Office

Office européen
des brevets

**PARTIAL EUROPEAN SEARCH REPORT**

under Rule 62a and/or 63 of the European Patent Convention.
This report shall be considered, for the purposes of
subsequent proceedings, as the European search report

**Application Number**

EP 24 15 1851

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | JONATHAN I TAMIR ET AL: "Unsupervised Deep Basis Pursuit: Learning Reconstruction without Ground-Truth Data", PROCEEDINGS OF THE INTERNATIONAL SOCIETY FOR MAGNETIC RESONANCE IN MEDICINE, 27TH ANNUAL MEETING AND EXHIBITION, MONTREAL, QC, CANADA, 11-16 MAY 2019, vol. 27, 660, 26 April 2019 (2019-04-26), XP040708047, * the whole document * | | INV. G01R33/56 ADD. G01R33/561 |
| T | DAVE VAN VEEN ET AL: "Using Untrained Convolutional Neural Networks to Accelerate MRI in 2D and 3D", PROCEEDINGS OF THE INTERNATIONAL SOCIETY FOR MAGNETIC RESONANCE IN MEDICINE, 29TH ANNUAL MEETING AND EXHIBITION, 15-20 MAY 2021, vol. 29, 1964, 30 April 2021 (2021-04-30), XP040723983, * the whole document *  -/-- | | |

|  |  |
|---|---|
| | **TECHNICAL FIELDS SEARCHED (IPC)** |
| | G01R |

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 10 September 2024 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                     

& : member of the same patent family, corresponding document

EPO FORM 1503 03.82 (P04E07)

page 1 of 2

Europäisches
Patentamt

European
Patent Office

Office européen
des brevets

**PARTIAL EUROPEAN SEARCH REPORT**

Application Number

EP 24 15 1851

## DOCUMENTS CONSIDERED TO BE RELEVANT

| Category | Citation of document with indication, where appropriate, of relevant passages | Relevant to claim |
|---|---|---|
| X | US 2019/346522 A1 (BOTNAR RENE [GB] ET AL) 14 November 2019 (2019-11-14) * paragraphs [0096] - [0102], [0108] - [0119]; figure 4 * | 1-6,14, 15 |

----- 

**CLASSIFICATION OF THE APPLICATION (IPC)**

**TECHNICAL FIELDS SEARCHED (IPC)**

EPO FORM 1503 03.82 (P04C10)

3

Europäisches
Patentamt

European
Patent Office

Office européen
des brevets

**INCOMPLETE SEARCH
SHEET C**

Claim(s) searched incompletely:
        1-6, 14, 15

Claim(s) not searched:
        7-13

Reason for the limitation of the search:

The reasons for which the application is considered not to comply with
the requirements of Art. 83 and 84 EPC to the extent that a meaningful
search regarding the state of the art on the basis of the subject-matter
of claims 1-15, i.e. the entire subject-matter as claimed, is not
possible (Rule 63(1) EPC) are specified in the annexed opinion
accompanying the incomplete search results (EPO Form 1703).

As a service to the applicant however, the following subject-matter,
corresponding to an amended version of claim 1, was searched:
"Computer implemented method for magnetic resonance, MR, image
reconstruction, wherein MR measurement data representing an imaged object
is obtained and, for each iteration of at least two iterations,
a) a prior MR image for the respective iteration is received;
b) an optimized MR image is generated by optimizing a predefined first
loss function, which depends on the MR measurement data and on the prior
MR image;
c) an enhanced MR image is generated by applying [an algorithm] for image
enhancement to the optimized MR image; and
d) the prior MR image of the respective iteration corresponds to the
enhanced MR image of a preceding iteration, unless the respective
iteration corresponds to an initial iteration of the at least two
iterations, and the prior MR image of the initial iteration corresponds
to a predefined initial image".

Therefore, one may consider that  claim 1, as amended above, was
partially searched, along with claims 2-6, 14 and 15, when referring
exclusively to claim 1 as amended above.

## ANNEX TO THE EUROPEAN SEARCH REPORT
## ON EUROPEAN PATENT APPLICATION NO.

EP 24 15 1851

This annex lists the patent family members relating to the patent documents cited in the above-mentioned European search report.
The members are as contained in the European Patent Office EDP file on
The European Patent Office is in no way liable for these particulars which are merely given for the purpose of information.

10-09-2024

| Patent document cited in search report | Publication date | Patent family member(s) | Publication date |
|---|---|---|---|
| US 2019346522 A1 | 14-11-2019 | GB 2573557 A | 13-11-2019 |
| | | US 2019346522 A1 | 14-11-2019 |

EPO FORM P0459

# EP 4 585 953 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. ZENG et al.** A review on deep learning MRI reconstruction without fully sampled k-space. *BMC Med Imaging*, 2021, vol. 21, 195
- **O. RONNEBERGER et al.** U-Net: Convolutional Networks for Biomedical Image Segmentation. *arXiv:1505.04597v1*
- **D. POLAK et al.** Wave-CAIPI for highly accelerated MP-RAGE imaging. *Magnetic resonance in medicine*, 2018, vol. 79.1, 401-406
- **K.P. PRUESSMANN et al.** SENSE: sensitivity encoding for fast MRI. *Magn Reson Med*, 04 November 1999, vol. 2 (5), 952-62
- **K.P. PRUESSMANN et al.** Advances in Sensitivity Encoding With Arbitrary k-Space Trajectories. *Magn Reson Med*, 2001, vol. 46, 638-651
- **M. UECKER et al.** ESPIRiT - an eigenvalue approach to autocalibrating parallel MRI: where SENSE meets GRAPPA. *Magn Reson Med.*, 07 March 2014, vol. 1 (3), 990-1001
- **M. W. HASKELL et al.** TArgeted Motion Estimation and Reduction (TAMER): data consistency based motion mitigation for MRI using a reduced model joint optimization.. *IEEE transactions on medical imaging 37.5*, 2018, 1253-1265
- **D. POLAK et al.** Scout accelerated motion estimation and reduction (SAMER).. *Magnetic Resonance in Medicine*, 2022, vol. 87.1, 163-178
- **M. W. HASKELL et al.** Network accelerated motion estimation and reduction (NAMER): convolutional neural network guided retrospective motion correction using a separable motion model. *Magnetic resonance in medicine*, 2019, vol. 82.4, 1452-1461